# EUROPEAN PATENT SPECIFICATION

(11) **EP 2 243 858 B1**
(45) Date of publication and mention of the grant of the patent: **29.04.2015**
(21) Application number: 09709857.8
(22) Date of filing: 10.02.2009
(51) Int. Cl.: C23C 16/27, C23C 16/44, C23C 16/505, C23C 16/515, C23C 16/04

(54) **DIAMOND-LIKE CARBON FILM FORMING APPARATUS AND METHOD FOR FORMING DIAMOND-LIKE CARBON FILM**
VORRICHTUNG ZUR HERSTELLUNG EINES DIAMANTARTIGEN KOHLENSTOFFFILMS UND VERFAHREN ZUR HERSTELLUNG EINES DIAMANTARTIGEN KOHLENSTOFFFILMS
APPAREIL DE FORMATION DE FILM DE CARBONE SOUS FORME DE DIAMANT AMORPHE ET PROCÉDÉ POUR FORMER UN FILM DE CARBONE SOUS FORME DE DIAMANT AMORPHE

(30) Priority: 12.02.2008 JP 2008030895
(43) Date of publication of application: 27.10.2010
(73) Proprietor: iMott Inc., Kanagawa 225-0012 (JP)
(72) Inventor: OHTAKE, Naoto, Yokosuka-shi Kanagawa 239-0807 (JP); MATSUO, Makoto, Yokohama-shi Kanagawa 225-0012 (JP); IWAMOTO, Yoshinao, Hujimi-shi Saitama 354-0026 (JP)
(74) Representative: Becker Kurig Straus
(86) International application number: PCT/JP2009/052587
(87) International publication number: WO 2009/102070

(56) References cited:
- JP-A- 5 024 986
- JP-A- 2002 100 573
- JP-A- 2003 147 525
- JP-A- 2005 282 668
- US-B1- 6 223 686
- US-B1- 6 517 913
- FUJII Y ET AL: "P6E-3 Surface Acoustic Wave Linear Motor Using Segment-Structured Diamond-Like Carbon Films on Contact Surface", ULTRASONICS SYMPOSIUM, 2007. IEEE, IEEE, PISCATAWAY, NJ, USA, 1 October 2007 (2007-10-01), pages 2543-2546, XP031195531, DOI: DOI:10.1109/ULTSYM.2007.640 ISBN: 978-1-4244-1383-6
- AOKI Y ET AL: "Tribological properties of segment-structured diamond-like carbon films", TRIBOLOGY INTERNATIONAL, BUTTERWORTH SCIENTIFIC LDT, GUILDFORD, GB, vol. 37, no. 11-12, 1 November 2004 (2004-11-01), pages 941-947, XP004614314, ISSN: 0301-679X, DOI: DOI:10.1016/J.TRIBOINT.2004.07.011
- AOKI, Y. ET AL.: 'Tribological properties of segment-structured diamond-like carbon films' TRIBOLOGY INT. vol. 37, November 2004, ISSN 0301-679X pages 941 - 947

## Description

### TECHNICAL FIELD

The present invention relates to a diamond-like carbon film forming apparatus and a method of forming a diamond-like carbon film. Specifically, the diamond-like carbon film forming apparatus of the present invention surrounds a substrate on which the film is to be formed by a conductive mask material, or brings it into contact with a conductive mask material, supplies voltage between that substrate and material and a chamber to form plasma inside the chamber, and thereby forms a diamond-like carbon film on the substrate. Further, the method of forming a diamond-like carbon film uses the diamond-like carbon film forming apparatus of the present invention to form a diamond-like carbon film by plasma chemical vapor deposition.

### BACKGROUND ART

An apparatus forming a diamond-like carbon film (DLC) using plasma chemical vapor deposition (CVD) is comprised of 1) a vacuum chamber system (vacuum tank, hereinafter referred to as a "chamber"), 2) a vacuum pump etc. and an apparatus for lowering the pressure in the chamber to a low pressure of about 10⁻⁵ Torr, that is, an exhaust system, 3) a gas introduction system for introducing feed gas for forming the film into the chamber, 4) a power supply for breaking down and disassociating the feed gas to form a DLC film on the substrate, 5) a power supply system comprised of electrodes, a power output control console, etc., and a system control console for simultaneously controlling the systems of 1) to 5), for a total of six hardware systems.

The chamber is designed in accordance with the size and type of the substrate on which the film is to be formed, while the exhaust system is designed in accordance with the size of the chamber. Similarly, the gas introduction system is selected in accordance with the type or flow rate of the gas used, while the power supply system is set in output in accordance with a surface area and material of the substrate. Further, the power supply system supplies either a DC single pulse power or a high frequency power to the substrate. Current DLC film forming apparatuses, as explained above, have most of their component apparatuses selected in accordance with the substrates at the present. Already, most Japanese and foreign hardware manufacturers are forming DLC films by their own film-forming methods by chemical vapor deposition (CVD) based on the plasma chamber capacity, power output, etc.

As DLC film forming apparatuses using CVD, a DC plasma system (Japanese Patent Publication (A) No. 2003-336542, November 28, 2007, High Abrasion Resistant and High Seizing Resistant Sliding Member and Method for Production of Same), a high frequency plasma system (for example, K. Kobayashi et al.: Journal of the Japan Society of Powder and Powder Metallurgy, 33 (1986) 402), a plasma ion injection film forming apparatus (PBII system, Japanese Patent Publication (A) No. 2001-26887, January 30, 2001, Surface Modification Method and Surface Modification Apparatus), a pulse high frequency system (Japanese Patent Publication (A) No. 10-204644, August 4, 1998, Plasma CVD Method and Apparatus), a DC pulse system (for example, Japanese Patent Publication (A) No. 2006-52453, February 23, 2006, Method of Production of Thin Film and Thin Film of Same and Y. Aoki, Journal of the Japan Society for Precision Engineering, Papers, 71 (2005), 1558), a peening ionization gauge discharge system (PIG discharge system, Japanese Patent Publication (A) No. 2006-169562, June 29, 2006, Surface Treatment Apparatus), etc. may be mentioned. Fujii et al. discloses a method and apparatus for coating a DLC layer on a planar substrate using a mesh type electrode ("P6E-3 Surface Acoustic Wave Linear Motor Using Segment-Structured Diamond-Like Carbon Films on Contact Surface", ULTRASONICS SYMPOSIUM, 2007. IEEE, IEEE, PISCATAWAY, NJ, USA, 1 October 2007 (2007-10-01), pages 2543-2546). Further, in physical vapor deposition (PVD) as well, as a method close to chemical vapor deposition (CVD), an ionization deposition system (Japanese Patent Publication (A) No. 2001-26873, January 30, 2001, Hard Carbon Film Forming System), an unbalance magnetron sputter system (Japanese Patent Publication (A) No. 2002-256415, September 11, 2002, Diamond-Like Carbon Hard Multilayer Film Shaped Article and Method of Production of Same), a plasma booster system (T. Kumagai et al., Material Trans. 47, 4 (2006) 1008), etc. may be mentioned. In the above example of the CVD system, the chamber capacity is about 0.3 to 3 m³, and the gas used is, for forming a DLC film, acetylene, methane, ethane, ethylene, benzene, toluene, or other hydrocarbon gas and, for doping the intermediate layer or DLC film, tetramethylsilane (TMS), trimethylsilane, dimethylsilane, monosilane, tetramethyldisilazane, etc.

Operation of the above film forming apparatuses requires skilled labor. The vacuum degree has been confirmed, the amount of gas introduction, timing of introduction, and voltage have been confirmed, the timing of change of output and further the thickness of the formed film have been predicted, etc. in film formation by the experience and skill of the workers. Work manuals are prepared for each substrate on which film is to be formed and for each part in film formation. The workers look at these while working at the present time. Therefore, realization of an apparatus enabling automatic selection of the film forming process and automatic formation of the DLC film if designating the substrate on which the film is to be formed would be extremely desirable.

In physical vapor deposition (PVD) types of vapor deposition apparatuses and semiconductor production apparatuses, if differences due to the individual workers, slight time deviations, or other factors cause the resultant articles and products to differ, these will be rated as substandard, that is, as defects, so the current practice is to load a program (sequence) at the hardware side so that the same result is produced by the same production process no matter how many times it is performed. However, in DLC film forming apparatuses using CVD, some manufacturers use dialog type sequences with the apparatuses to form DLC films semiautomatically. The reason is that strict film thicknesses or film characteristics (hardness distribution, density, Young's modulus, etc.) are not demanded and the later described abnormal discharge etc. suddenly occur and other unforeseen situations easily arise. Therefore, the user can indicate its understanding even when an apparatus as a whole is used in an unskilled environment. Therefore, to realize fully automated operation, an apparatus and control mechanism provided with a program and control mechanism for maintaining discharge output for maintaining the film formation conditions of the DLC film and automatically preventing abnormal discharge have been desired. Furthermore, an apparatus for automatically changing and switching the type of the gas used, changing the flow rate of the same, etc. and a control mechanism for running a program for the same have been desired.

Further, in general, the method is being employed of using argon gas (Ar) before the formation of the DLC film, bombarding the surface of the substrate on which the film is to be formed with argon ions, and thereby cleaning it. The oxides and other dust stripped from the substrate surface at this time float up in the chamber and are exhausted by the vacuum pump, but with just a slight amount of argon gas being run in a state already reduced to a 10⁻⁵ Torr or less vacuum, not all of the dust is necessarily exhausted from inside of the chamber. Further, the dust ends up settling on the substrate in many cases. This results in contamination by dust and other particulate, that is, film-forming defects. Therefore, for realizing fully automated operation, it is necessary to provide a program and control mechanism suppressing contamination by particulate and performing cleaning automatically.

On the other hand, it is known that abnormal discharge occurs in a chamber. Abnormal discharge easily occurs at projections inside the chamber, the observation window, holes of the exhaust system, and other surface relief shapes where the electric field concentrates. To prevent this, the surface relief parts are made electrically floating in state or the effects of holes are reduced by covering them by a metal net of the same potential as the chamber. Therefore, to realize fully automated operation, it is necessary to provide a mechanism and program and a control mechanism for avoiding abnormal discharge.

A substrate of a polymer formed from rubber, a synthetic resin, etc. is exposed to the plasma and thereby easily heated to the glass transition point Tg (for a material without a Tg, the melting point Tm) or a higher temperature and ends up changing in properties. Formation of a DLC film was difficult. With formation of a high frequency induction type DLC film using a high frequency power supply (mainly 13.56 MHz), the temperature of the substrate on which the film is formed ends up becoming high, so this is reportedly not suited for general film formation. However, this is not necessarily so in the case of a thin film thickness (5 to 100 nm or so) or in the case where the surroundings are protected by a heat absorbing material etc. to prevent a temperature rise. As one example, there is the formation of a DLC film at the inside surface of a polyethylene terephthalate bottle (PET bottle). In this case, the film thickness is 5 to 100 nm or so.

In the above way, in a CVD system having a plasma generating mechanism using high frequency induction, if trying to form a DLC film on metal, the temperature of the substrate on which the film is formed rises. However, this function of raising the temperature of the substrate in accordance with the objective is not general practice in a DLC film forming apparatus. Further, it is not seen in DLC film forming apparatuses which do not make the substrate rotate and orbit or otherwise move.

In a high frequency plasma CVD system, under DLC film formation conditions, the temperature usually rises to about 200 to 300°C. Therefore, to raise the temperature to one for nitriding the substrate, the high frequency (RF) power supply has to be made one with that much larger an output or a separate mechanism for heating the substrate (halogen heater etc.) has to be provided inside the chamber. Furthermore, with the RF system, the heating is induction heating, so uneven spots easily occur in the surface temperature of the substrate. To prevent this, there are apparatuses employing a rotating and orbiting system, but as a result the apparatus ends up becoming complicated in structure or the problem arises of the film-forming cost ending up rising as well. This is obstructing the spread of DLC films.

Further, in the formation of a DLC film, the inside surfaces of the chamber, fixtures, and electrodes are covered by films comprised of DLC, carbon, and hydrogen and further the sputtered substrate substance, so with each batch (process of closing the lid of the chamber, forming a DLC film, then opening the lid), the discharge state changes. Further, there is the problem that the deposited film comprised of the carbon and hydrogen and the sputtered substrate substance act as impurities contaminating the DLC film at the time of the formation of the next batch. Therefore, to prevent this contamination, it was necessary to perform plasma cleaning or sandblasting to remove the deposits every batch or every several batches.

### DISCLOSURE OF INVENTION

The present invention provides a diamond-like carbon film forming apparatus and method using plasma-chemical vapor deposition according to claims 1 and 10. The apparatus integratedly controls a chamber, an exhaust system, a gas introduction system, and a power supply system so as to form by automatic control a segment structure DLC film which has a 10 GPa or more desired nanoindentation hardness and a desired film thickness on a polymer substrate comprised of a polymer material etc. or a metal substrate comprised of a ferrous metal etc.

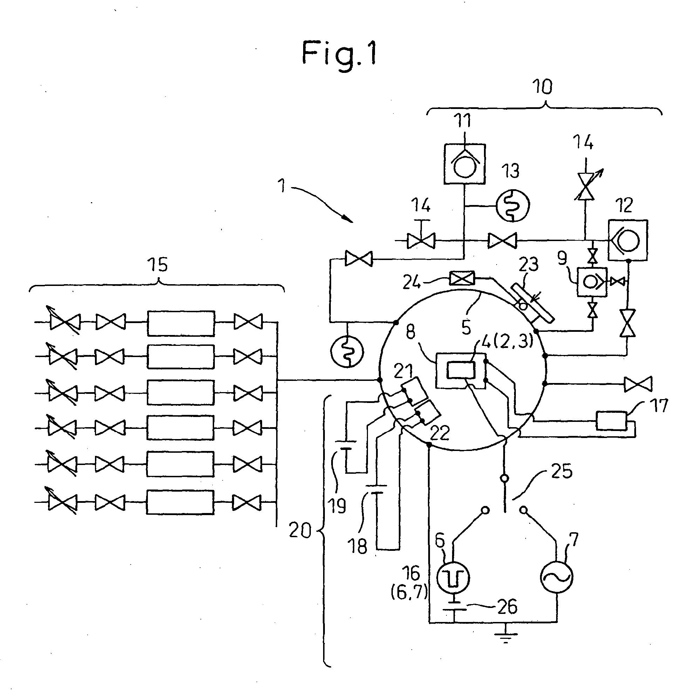

FIG. 1 shows a diamond-like carbon film forming apparatus 1 of the present invention provided with a chamber 5, an exhaust system 10 (rotary pump 11, turbomolecular pump, or diffusion pump 12, manometer 13, leak valve 14, etc.), gas introduction system 15 (Ar, C₂H₂, Si(CH₃)4), H₂, O₂, N₂, CH₄, CF₄, or other gas introduction valve), and power supply system 20 (main power supply 16, substrate heating power supply 17, particulate trap filter power supply 18, excess electron collecting power supply 19, etc.)

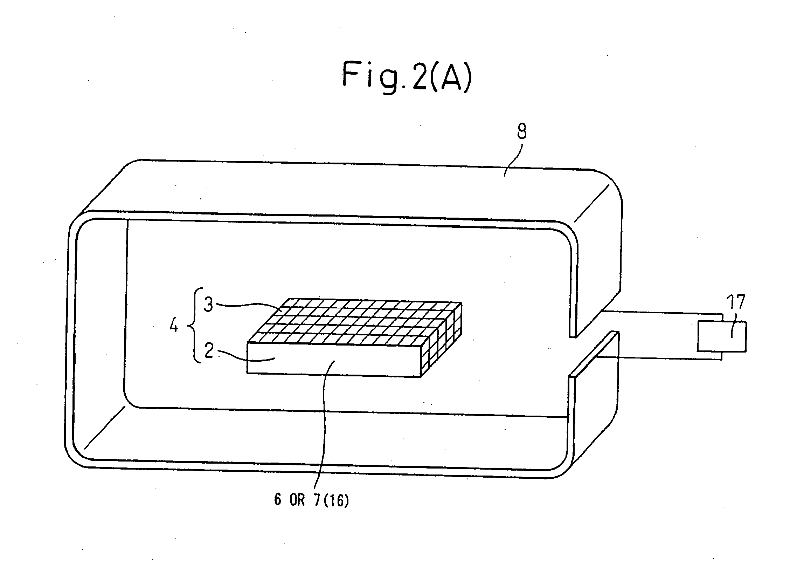

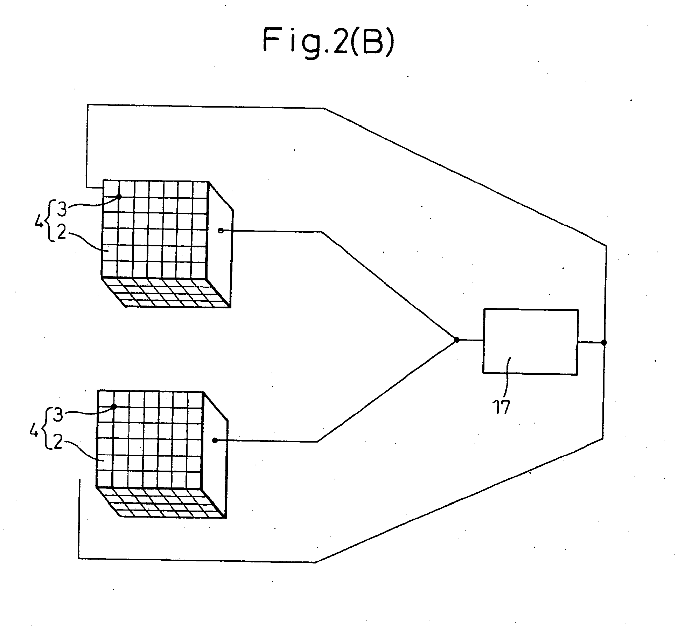

FIG. 2A shows an example of a member comprised of a substrate 2 and a mask material 3 set in the chamber 5 of the present apparatus and induction heating of that member by a heating heater 8. Further, FIG. 2B shows an example of a member 4 comprised of a substrate 2 and a mask material and direct ohmic heating of that member. In the apparatus of the present invention, a cathode electrode of the main power supply 16 is connected to the member 4 comprised of the substrate 2 surrounded by the mask material 3, while an anode electrode of the main power supply 16 is connected to a wall of the chamber 5. The chamber 5 is electrically grounded for safety. Further, in one example of the apparatus of the present invention (FIG. 2A), the member 5 comprised of the substrate 2 and the mask material 3 can be heated by the heating heater 8 obtaining power from the substrate heating power supply 17 so as to be raised to a predetermined film-forming temperature. The heating heater may be one which uses a halogen heater or other radiant heat. As explained above, while the member 4 can be heated by radiant heat, the above-mentioned heater can also be brought into direct contact with the member 4 for heating. In addition, as shown in FIG. 2B, there is the method of using an AC power supply, DC power supply, or DC pulse power supply for ohmic heating of the substrate.

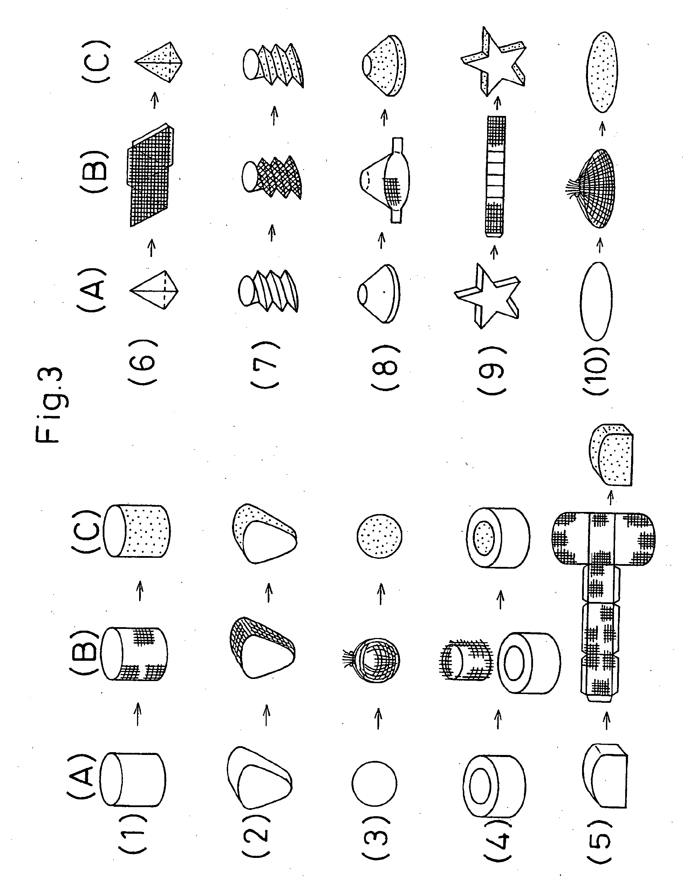

Furthermore, the present invention provides not only a method of production of a segment structure DLC film using a metal net conventionally used as the mask material of a substrate, but also a method of production using a net-shaped mask material of polyacetylene, carbon black-containing polycarbonate, or other conductive polymer material. These various conductive net-shaped mask materials are used to surround different shapes (FIG. 3, 1 to 10) of and combinations of shapes of substrates, then a DLC film is formed on the substrate surrounded by the net-shaped mask material, then further this net-shaped mask material is removed to thereby obtain a substrate covered by an island-shaped segment structure DLC film. FIG. 3 shows various shapes of substrates (A) before film formation, the substrates (B) surrounded by the net-shaped mask materials, and the substrates (C) on which the DLC films are formed after removal of the net-shaped mask materials.

In FIG. 3, the substrate of (1) is a cylindrical shape, the substrate of (2) is a cam shape, the substrate of (3) is a spherical shape, the substrate of (4) is the inside of a pipe, the substrate of (5) is a combination of a block shape and curved surface, the substrate of (6) is a pyramid shape, the substrate of (7) is a spiral columnar shape, the substrate of (8) is a frustoconical shape, the substrate of (9) is a star shape, and the substrate of (10) is a ovoid shape. In the method of the present invention, these substrates are covered by net-shaped mask materials (respective "B's" in FIG. 3), DLC films are formed, then these net-shaped mask materials are removed, whereupon these substrates (respective "C's" in FIG. 3) are formed with segment structure DLC films on predetermined surfaces. Note that when forming a film on a substrate of a polymer material and when forming a film on a substrate of a ferrous material, the films are not formed by simultaneous batches, but are formed by separate batches.

In the conventional formation of a DLC film by CVD, the output was also controlled, but this was only for maintaining a constant power supply voltage or power supply current setting or for changing the output in accordance with the setting. The plasma state is a state of an extremely low pressure where the atoms are disassociated, so the disassociation ability differs depending on the concentration and type of the gas, the arrangement and conductivity of the substrate, etc., so maintaining it constant is difficult. Under different film-forming conditions, the power supply voltage, power supply current, discharge voltage, and discharge current are not the same. Along with the elapse of time, even if the set power supply voltage is constant, the discharge voltage will change, or even if the set power supply current is constant, the discharge current will change in some cases. This has resulted in differences in properties of each batch of DLC films. As opposed to this, in the apparatus of the present invention, the discharge voltage and discharge current actually applied to the substrate are monitored independently of the set voltage or set current by an oscilloscope connected to a connecting part feeding power to the member 4 or chamber 5. It is provided with a feedback function under a process of constant discharge conditions so that the discharge voltage or discharge current becomes a constant value within ±5% of the set discharge voltage and the set discharge current. It has the feature of enabling integrated control of not only the settings of the power supply voltage and power supply current, but also the type and feed rate of the film-formng feed gas, the pressure inside the chamber, the later described anode voltage for collecting excess electrons, and the heating heater. This control by the present invention enables the properties of the DLC film of different batches to be maintained generally constant.

The present invention is a film-forming apparatus which, when using DC pulse plasma CVD to form a DLC film of a substrate of a polymer material, places a conductive net on the surface of the substrate where the film is to be formed and supplies this net with a -2 kV to -20 kV DC pulse voltage superimposed on the DC voltage (0 to - 2000V) under conditions of a pulse width of 1 to 100 microseconds and a repetition frequency of 1 to 30 kHz, where the product of the pulse width and the repetition frequency is 0.8 or less, so as to form a DLC film at the openings of this net-shaped mask material. In this case, the temperature of the substrate is 200°C or less, more preferably less than the glass transition point temperature Tg of the substrate (for a material with no Tg, less than the melting point). The apparatus of the present invention has a mechanism which stores the glass transition point temperature in the apparatus and thereby enables film formation at the desired temperature by measurement of the temperature at the time of film formation. In the film-forming flow, it uses a contact/non-contact temperature measurement device to measure the temperature, adjust the power supply output, change the pressure change, or perform feedback control on the other film formation conditions. For example, in the case of a polyethylene, nylon, polyurethane, polypropylene, rubber, epoxy, polyacetal (POM), acryl resin (PMMA), Teflon®, or polycarbonate (PC) substrate, it has a mechanism for forming the film at a substrate temperature of 20 to 100°C, more preferably 40 to 70°C. Further, in the case of polyether ether ketone (PEEK), polyamide, polyimide, polyphenylene sulfide (PPS), or fiber composite materials of the same, it has a mechanism for forming the film at a substrate temperature of 40 to 200°C, more preferably 100 to 120°C.

The present invention, furthermore, is a film forming apparatus having a mechanism which, when using high frequency plasma CVD to form a DLC on a polymer material substrate, similarly sets a conductive net-shaped mask material on the surface of the substrate and applies a 40W to 10kW high frequency power to this net under conditions of a frequency 6.5 to 60MHz and a DC self bias voltage of -50 to -750V so as to form DLC film in the openings of this net-shaped mask material. Furthermore, preferably, the frequency can be selected between 13.56 to 60 MHz and the DC self bias voltage can be selected between -100 to -500V. In this case, the temperature of the substrate is 200°C or less, more preferably less than the glass transition point temperature Tg of the substrate (for a material with no Tg, less than the melting point). The apparatus of the present invention has a mechanism which stores the glass transition point temperature in the apparatus and thereby enables film formation at the desired temperature by measurement of the temperature at the time of film formation. In the flow of film formation, it uses a contact/non-contact temperature measuring device to measure the temperature, adjust the power supply output, change the pressure, and otherwise provided feedback in the film formation conditions. For example, in the case of a polyethylene, nylon, polyurethane, polypropylene, rubber, epoxy, polyacetal (POM), acryl resin (PMMA), Teflon®, or polycarbonate (PC) substrate, the apparatus has a mechanism for forming the film at a temperature of the substrate of 30 to 100°C, more preferably 40 to 70°C. Further, in the case of polyether ether ketone (PEEK), polyamide, polyimide, polyphenylene sulfide (PPS), and fiber composite materials of the same, it has a mechanism for forming the film at a temperature of the substrate of 50 to 200°C, more preferably 100 to 120°C.

Next, the present invention is a film forming apparatus having a mechanism using DC pulse plasma CVD to form a DLC film on a ferrous metal or other metal substrate, which system sets a conductive net-shaped mask material on the surface of the substrate and applies to the substrate and this net a -3kV to -30 kV DC pulse voltage under conditions of a pulse width of 1 to 100 micro sec and a repetition frequency of 1 to 30 kHz, where the product of the pulse width and repetition frequency is not more than 0.8, so as to form a DLC film in the openings of this net-shaped mask material. Further, a superimposition DC power supply (26) able to be connected in series with the DC single pulse power supply (6) is a power supply for applying a negative voltage to the substrate (4) when the pulse voltage of the DC single pulse power supply is 0V. The output of the superimposition DC power supply (26) is variable. The output voltage can be changed between 0V and -2000V in range. Preferably, the voltage is set to -30V to -1000V in range, but this is to eliminate instants when the output voltage of the power supply (6) overshoots to the + side in the instants when the single pulse voltage of the DC single pulse power supply (6) becomes 0V. If overshooting to the + side, the disassociated minus charged ions or minus charged particles enter into the surface on which the film is being formed. The purpose is to prevent or reduce this. Further, the present apparatus has a mechanism which can control the temperature of the substrate between 100°C and 720°C by a built-in heater and performs control enabling film formation at the desired temperature by measuring the temperature of the substrate at the time of film formation. In particular, in the present apparatus, in the case of using a ferrous metal substrate, the temperature of the substrate at the time of pretreatment is 150 to 720°C in range and the temperature of the substrate at the time of formation of the DLC film is 100 to 550°C. Furthermore, in the present invention, when nitriding the surface of the substrate before the formation of the DLC film, in addition to the substrate heating heater, it is possible to set a DC power supply or AC power supply separate from the DC pulse power supply. Therefore, it can supply the substrate with a DC voltage or AC voltage so as to nitride the plasma at a temperature of the substrate of 200 to 720°C. For a substrate of a metal material other than a ferrous metal material, it is possible to set the temperature to 10% to 80% of the melting point in range in a range not exceeding 720°C. For example, when the substrate is aluminum, in the temperature setting, when the temperature of the substrate before treatment is 100 to 520°C, the temperature of the substrate at the time of formation of the DLC is 100 to 540°C.

Furthermore, the present invention is a film forming apparatus having a mechanism using high frequency plasma CVD to form a DLC film on a ferrous metal or other metal substrate, which system similarly sets a conductive net-shaped mask material on the surface of the substrate and applies to this net-shaped mask material a 40W to 10kW high frequency power under conditions of frequency of 6.5 to 60 MHz and a DC self bias voltage of -80 to -1100V so as to form a DLC film in the openings of this net-shaped mask material. The apparatus has a mechanism for controlling the temperature of the substrate between 100°C and 720°C by a built-in heater and performing control enabling film formation at the desired temperature by measuring the temperature at the time of film formation. In particular, it is an apparatus which forms a film by a temperature of the substrate at the time of pretreatment in the case of a ferrous metal substrate of 150 to 720°C and by a temperature of the substrate at the time of formation of the DLC of 100 to 550°C. Furthermore, when nitriding the surface of the substrate before formation of the DLC film, in addition to a substrate heating heater, it is possible to set a DC power supply or AC power supply separate from the DC pulse power supply and supply DC voltage or AC voltage to the substrate so as to perform plasma nitridation at a temperature of the substrate of 200 to 720°C. When using a metal material other than a ferrous metal material for the substrate, it is possible to set the temperature in a range of 10% to 80% of the melting point in a range not exceeding 720°C. For example, regarding the temperature settings when the substrate is aluminum, the temperature of the substrate at the time of pretreatment is 100 to 520°C and the temperature of the substrate at the time of formation of the DLC film is 100 to 540°C.

### TECHNICAL SOLUTION

The diamond-like carbon film forming apparatus (1) using plasma chemical vapor deposition of the present invention is provided with
a chamber (5) and
a mechanism provided with a main power supply (16) comprised of a DC single pulse power supply (6) and/or high frequency power supply (7) and a switch (25) for selecting either the DC single pulse power supply or high frequency power supply, guiding the output of the film forming apparatus to the chamber (5), when selecting the DC single pulse power supply, connecting the anode electrode of the power supply to the chamber (5) and guiding the cathode electrode of the power supply through the chamber (5) to a member (4) inside the chamber, and, when selecting the high frequency power supply, connecting one of the electrodes of that power supply to the wall of the chamber (5) and guiding the other through the chamber (5) to a member (4) inside of the same,
inside the chamber (5),
making the member (4) one comprised of that substrate (2) surrounded by a conductive mask material (3) and connecting the member (4) to the cathode electrode of the main power supply (16) led inside the chamber (5),
supplying the power of the main power supply to that member (4), and
forming the DLC film, then removing the mask material (3) from the member (4) to form a segment structure diamond-like carbon film on the substrate (2).

Further, the diamond-like carbon film forming apparatus of the present invention is characterized by connecting a superimposition DC power supply (26) in series to the DC single pulse power supply (6).

Further, the diamond-like carbon film forming apparatus of the present invention is **characterized in that** the mask material (3) is a shaped article of a net shape or a plate shape having a plurality of openings and is made of a conductive polymer material or metal material.

Further, the diamond-like carbon film forming apparatus of the present invention is **characterized in that** the substrate (2) is a metal material or a polymer material of polyethylene, nylon, polyurethane, rubber, epoxy, polyacetal (POM), acryl resin (PMMA), Teflon®, polycarbonate (PC), etc.

Further, the diamond-like carbon film forming apparatus of the present invention is **characterized in that** the high frequency power supply (7) has a frequency of 13.56 MHz to 60 MHz in range.

Further, the diamond-like carbon film forming apparatus of the present invention is characterized by being provided with a heating heater (8) able to heat the member (4) to 100 to 720°C in temperature range and connected to a substrate heating power supply (17) or by being provided with a substrate heating power supply employing the ohmic heating method directly running current through the member (4) comprised of the substrate and mask material.

Further, the diamond-like carbon film forming apparatus of the present invention is characterized by being able to set a pulse peak voltage of the DC single pulse power supply (6) to -2 to -20 kV in range.

Further, the DC single pulse power supply (6) is characterized by being able to freely set the pulse output voltage to -2 kV to -20 kV in range or in that a superimposition DC power supply (26) connected to the power supply (6) in series can freely set the DC output voltage to 0 to -2000V in range.

Further, the diamond-like carbon film forming apparatus of the present invention is **characterized in that** the high frequency power supply (7) has a frequency of 13.56 to 60 MHz in range and can be set in its output voltage to 40W to 10 kW in range.

Further, the diamond-like carbon film forming apparatus of the present invention is characterized by being provided with a particulate trap filter (22) in the chamber and in that the particulate trap filter traps impurity-forming particulate by electrostatic action.

The particulate trap filter (22) is comprised of a third power supply (auxiliary DC power supply (18)) provided outside the chamber with an anode electrode and a cathode electrode led through and into that chamber. By supplying a 100 to 7000V voltage across the electrodes of that auxiliary DC power supply, the anode electrode or cathode electrode of that DC power supply traps particulate in the chamber.

Further, the diamond-like carbon film forming apparatus of the present invention is characterized by being provided with an excess electron collecting electrode (21) for collecting excess electrons present in the chamber.

The excess electron collecting electrode (21) is **characterized in that** an anode electrode and cathode electrode of a second power supply (auxiliary DC power supply (19)) provided outside of the chamber are guided to the inside of that chamber and in that a 5 to 500V voltage is supplied across the electrodes of the auxiliary DC power supply (19) to collect excess electrons in the chamber at that anode electrode.

Further, the diamond-like carbon film forming apparatus of the present invention is characterized by being provided with software and a software operating mechanism which, at the time of formation of the diamond-like carbon film, receives as feedback and processes information of a substrate temperature measurement mechanism, an oscilloscope set in a chamber power feed unit or other power feed measurement mechanism, a pressure measurement mechanism inside the chamber, etc. so as to automatically control the output voltage and output current of the DC single pulse power supply (6), the output voltage of the superimposition DC power supply (26), the output voltage or output current of the high frequency power supply (7), the type and feed rate of the film-forming feed gas, the pressure inside the chamber (5), the output voltage of the second power supply (19) collecting excess electrons, the output voltage of the third power supply (18) trapping particulate, and the output of the heating heater (8) for heating the member (4).

The method of forming a diamond-like carbon film using the above diamond-like carbon film forming apparatus of the present invention is characterized by supplying to the member (4) a negative single pulse voltage by both the power supplies of the superimposition DC power supply (26) and the DC single pulse power supply (6) connected in series with it or supplying to it the high frequency voltage of the high frequency power supply (7) and removing the mask material (3) after formation of the DLC to thereby form on the substrate (2) a segment structure diamond-like carbon film. It is **characterized in that** when supplying the DC single pulse voltage, the cathode electrode of the DC single pulse power supply (6) is connected to the member (4) and the anode electrode is connected to the chamber (5).

Further, the method of forming a diamond-like carbon film of the present invention is characterized by using a mask material made of a Ti-Ni (titanium-nickel) or other shape memory alloy of a rod shape, net shape, or having a plurality of openings so as to form a DLC, then removing the mask material to thereby form a segment structure diamond-like carbon film when the member (4) comprised of the substrate (2) surrounded by a conductive mask material of a net shape or having a plurality of openings has a 50°C or higher temperature.

Regarding the above methods, the film formation conditions differ depending on the substrate on which the DLC film is formed, but to form an island shaped segment structure DLC film, various mask materials become necessary. When the mask material is formed by a metal net, it was difficult to reliably press and attach the mask material made of this metal net at the necessary parts of a 3D object. In the present invention, it is made possible to make this mask material a sufficiently soft material to enable the formation of a segment structure DLC film at desired parts of a 3D object. For this purpose, the mask material is made a net and cords of a conductive polymer material or a cloth provided with a plurality of openings. When the substrate (2) for formation of the DLC film is a polymer material, the substrate (2) is masked by a net and cords or a cloth having a plurality of openings made of a conductive polymer material to form a predetermined island shaped segment structure.

Further, when this substrate is made of a metal, except when using the above-mentioned conductive polymer material, as the mask material, it is possible to use a metal net, metal perforated plate, metal wire, or metal coil spring shaped fastening member etc. For these fastening members forming the mask material, a material provided with openings at the necessary parts is used so as to form a predetermined segment structure DLC film.

Under conditions where the temperature of a substrate (2) made of a metal becomes 50°C or more, as the mask material, it is possible to use a shape memory alloy and utilize the shape memory ability of the alloy forming the mask material so as to give the effect of pressing the mask material against the substrate (2). As this shape memory alloy, a titanium-nickel system is used, but even other alloys may be used if having shape memory properties. Further, the initial state of this shape memory alloy may be a net, plate, rod, wire, coil spring, or other shape. It is sufficient that it be one enabling the formation of openings for forming a segment structure DLC film.

When fastening the mask material, that is, the opening forming material, on to the substrate (2), sometimes incomplete parts are formed where complete shapes of island-shaped segment structure DLC film cannot be formed. In this case, these incomplete parts can be set at parts with a low need for an island-shaped structure when viewing the formed DLC film as a whole, so the effect of the segment structure DLC film is not lowered.

### ADVANTAGEOUS EFFECTS OF INVENTION

The diamond-like carbon film forming apparatus using plasma chemical vapor deposition of the present invention in particular enables the formation of a diamond-like carbon film on a substrate surrounded by a conductive mask material. The diamond-like carbon film of the present invention on the substrate from which the mask material has been removed after film formation is formed on the substrate in the form of a large number of island shapes. Such a substrate with a diamond-like carbon film of a form of a large number of island shapes of the present invention is attached to a sliding and rotating product. Even if the substrate itself deforms together with the product, this island-shaped film can sufficiently follow the deformation of the substrate, so this film is resistant to cracking, peeling, etc.

Further, the substrate formed with the diamond-like carbon film by the apparatus of the present invention can be provided with a lubricant in the grooves formed between the islands of the film formed in the island shapes, so when the substrate formed with the film is used as a sliding or rotating member, it is possible to improve the lubricating ability with the member sliding or rotating with this substrate. Furthermore, the grooves formed between the island shapes can trap parts peeled off from the sliding member due to rubbing, so it is possible to greatly reduce the rise of the coefficient of friction due to peeling, the formation of scratches, the generation of heat, and other effects.

### BRIEF DESCRIPTION OF DRAWINGS

FIG. 1 is a view showing an outline of an apparatus of the present invention provided with a chamber, an exhaust system (rotary pump, turbomolecular pump, vacuum meter, leak valve, etc.), a gas introduction system (valves for introduction of various types of gases), and a power supply system (main power supply, substrate heating power supply, particulate trap filter power supply, excess electron collecting power supply, etc.)
FIG. 2A shows an outline of the arrangement of a heating heater for heating a member (4) comprised of a substrate and mask material set in a chamber of the present invention.
FIG. 2B shows an outline of a mechanism for ohmic heating of a member (4) comprised of a substrate and mask material set in a chamber of the present invention.
FIG. 3 shows various shapes of substrates (2) before film formation (FIG. 3A), members (4) surrounded by mask materials (3) (FIG. 3B), and substrates (2) formed with DLC films after removal of the mask materials (FIG. 3C).
FIG. 4 shows a particulate trap filter connected to a particulate trap filter power supply for preventing particulate in the chamber of the present apparatus from contaminating the DLC film.
FIG. 5A is a flow chart of the preparation of a basic program of the operating routine of the present apparatus etc.
FIG. 5B is a flow chart of the preparation of a basic program of the operating routine of the present apparatus etc.
FIG. 5C is a flow chart of the preparation of a basic program of the operating routine of the present apparatus etc.
FIG. 5D is a flow chart of the preparation of a basic program of the operating routine of the present apparatus etc.
FIG. 5E is a flow chart of the preparation of a basic program of the operating routine of the present apparatus etc.
FIG. 5F is a flow chart of the preparation of a basic program of the operating routine of the present apparatus etc.
FIG. 5G is a flow chart of the preparation of a basic program of the operating routine of the present apparatus etc.
FIG. 5H is a flow chart of the preparation of a basic program of the operating routine of the present apparatus etc.

### BEST MODE FOR CARRYING OUT THE INVENTION

### Examples

The present apparatus has a mechanism opening and closing a valve set at a chamber side of a vacuum pump so as to maintain the pressure in a film forming process comprised of a pretreatment process and a film formation process at a constant 0.03 Pa to 100 Pa in range by a ±5% precision. Further, the present apparatus has a control mechanism for changing the pressure during the film forming process. This control mechanism sets the initial pressure values for the pretreatment process and the film formation process in advance in a program.

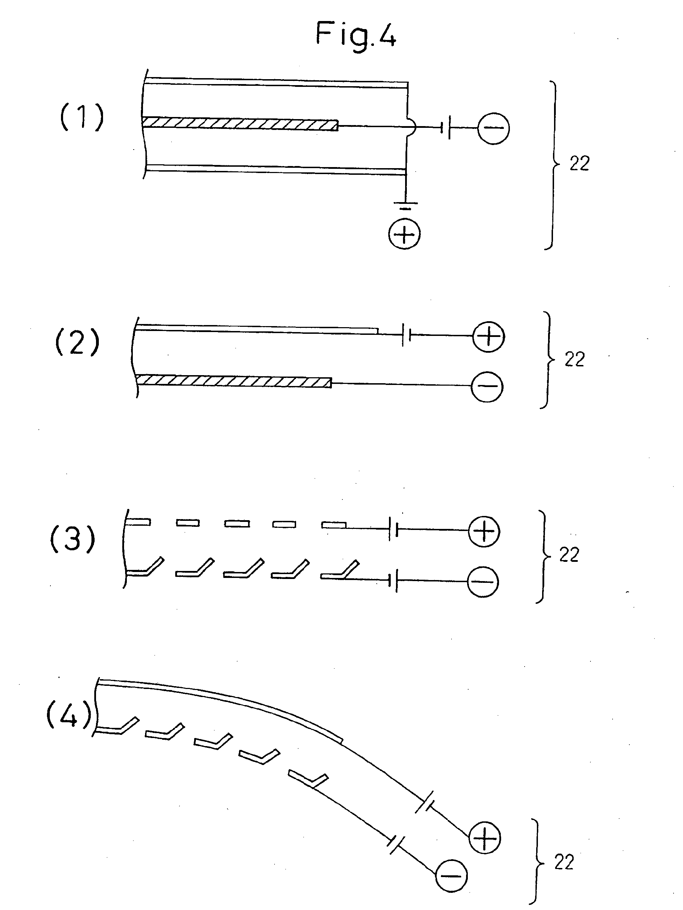

The present apparatus prevents the particulate in the chamber from contaminating the DLC film by providing a particulate trap filter connected to a particulate trap filter power supply (FIG. 1, 18) (various shapes shown in FIG. 4). The particulate trap filter is provided with a DC power supply independent from the power supply for forming the DLC film. Further, the particulate trap filter, as illustrated in (1) of FIG. 4, can be made an electrode structure of a cathode (-) comprised of a single plate provided with a net shape or opening shape sandwiched between two anodes (+). This electrode structure sets the distance between the two plates of the two electrodes to less than the plasma seed length so as to trap positively charged particulate on the cathode. For example, at the time of formation of a DLC film by pulse plasma, with an acetylene material and a pressure of about 5 Pa, the seed length, including the preseed, is about 5 mm, so the distance between electrodes of the particulate trap filter is made 3 mm and a 100 to 7000V, preferably 200 to 1000V DC voltage is supplied across the electrodes. The cathode material has to be a conductive material. It may be a tungsten or a stainless steel metal material or, in addition to a metal material, a graphite material. Furthermore, the cathode material is a metal, mainly stainless steel. Preferably, the surface of the anode material is coated by metal titanium. Alternatively, it is an anode of a structure made of plate shaped titanium which has an oxygen getter effect.

Further, in the present invention, as shown in FIG. 4, (2) to (4), the cathode and anode of the particulate trap filter are shaped in accordance with the shape of the chamber and the position of the substrate on which the film is to be formed, that is, in single cathode and anode shapes (FIG. 4, 2), a cathode shaped as a perforated plate (FIG. 4, 3), and a shape curved at the two extremes (FIG. 4, 4).

Furthermore, the present apparatus, for the purpose of preventing abnormal discharge liable to occur at recesses or projections in the chamber due to excess electrons generated during the film formation, may be provided with an auxiliary anode connected to an excess electron collecting power supply (FIG. 1, 19). The auxiliary anode used as the anode for collecting excess electrons is set at the bottom of the chamber. As one example, it is possible to make it a stainless steel disk or a water cooled copper disk of a bottom area of about 1/16th the bottom area of the chamber and of a thickness of about 2 mm. The bottom surface and side surfaces of this anode are preferably made structures covered by earth bars. Further, this auxiliary anode preferably has a mechanism for changing the carried DC voltage between +5V to +500V in range.

The present apparatus, as shown in the flow chart, provides an excess electron collecting subroutine in the control so as to suppress abnormal discharge. Specifically, until an optical monitor (FIG. 1, 24) set at an optical monitor mounting flange (FIG. 1, (23)) no longer confirms discharge, the excess electron collecting electrode (FIG. 1, (21)) is supplied with a 0V to 500V DC positive voltage by the excess electron collecting power supply (FIG. 1, (19)) while raising it by 3V/min. A voltage value of the voltage at the time the abnormal discharge is extinguished plus 5V is held constant as the setting of the voltage to be supplied to the excess electron collecting electrode until the end of film formation. When not extinguished at 500V, the current state is maintained and an electron excess alarm is displayed. Note that at this time as well, the synthesis process continues. The optical monitor used here is comprised of a visible light sensor and its control system. When the intensity of the visible light exceeds a threshold value, it can be easily judged that there are many excess electrons in the flange and plasma is being produced. The threshold value can be freely set. Once matching the visual observation and the threshold value, automatic operation is possible the next time on. Due to this excess electron collecting method, it becomes possible to extinguish abnormal discharge in the flange (FIG. 1, (23)) by a voltage of about 90V under usual DLC forming conditions.

The present apparatus has a gas introduction system (FIG. 1, 15) using a mass flow controller to supply a predetermined gas into the chamber. The gas introduction system of the present apparatus, when, for example, the substrate is a ferrous metal material substrate, can supply the mass flow controller with Ar, hydrogen, oxygen, nitrogen, CF₄, tetramethylsilane, and acetylene by a 1 to 500 cc/min flow rate.

The present apparatus is provided with an output monitoring mechanism for constantly monitoring parameters during the film forming process comprised of the pretreatment process and film formation process such as the discharge pulse voltage, discharge pulse current or discharge high frequency voltage, discharge high frequency current, and discharge self bias value. It has a control mechanism holding these discharge voltage and discharge current constant within ±5%. The power supply of the present apparatus can be controlled by a digital signal by both automatic control and manual settings of a central control console. The output control parameters of the power supply of the present apparatus are the power supply voltage setting, power supply current setting, pressure inside the chamber, and anode voltage for collecting excess electrons. By optimally changing these four parameters, the discharge current and discharge voltage supplied to the substrate are held constant. Further, to detect exceptional abnormalities which cannot be judged by monitoring the discharge current and discharge voltage, an observation window and optical monitor mounting flange and a Langmuir probe mounting flange are provided.

In the present apparatus, the above-mentioned output control parameters of the power supply voltage setting, power supply current setting, pressure inside the chamber, and anode voltage for collecting excess electrons are respectively set with upper limit values. When these upper limit values are exceeded for a certain time period, an alarm is automatically issued and the discharge is stopped. For example, the above-mentioned "certain time period" is about 10 seconds. These upper limit values are the settings +30%, that is, in the case of a 30 kW power supply, 39 kW. The film forming DC pulse power supply is provided with a performance enabling an output of the set upper limit value +30% to be maintained for 10 seconds.

Further, in the present apparatus, when the film forming output exceeding the setting is an output of less than the setting +30%, control is periodically performed to make the discharge state approach the setting. For example, control is performed once every minute, preferably once every 5 seconds, so as to try to reduce the discharge voltage setting of the power supply toward the initial setting. Alternatively, control is performed by a similar cycle as the above to try to change the pressure inside the chamber toward the initial setting. This has the effect of extinguishing abnormal discharge when local abnormal discharge occurs.

The present apparatus can transmit a film forming program to a storage device part in a central control unit of the apparatus through a communication mechanism from outside the apparatus via the Internet or a USB memory or other storage device and can prepare for the next film formation simultaneously with monitoring the state during film formation unlike with the dialog method. Furthermore, it is characterized by the ability of remote control.

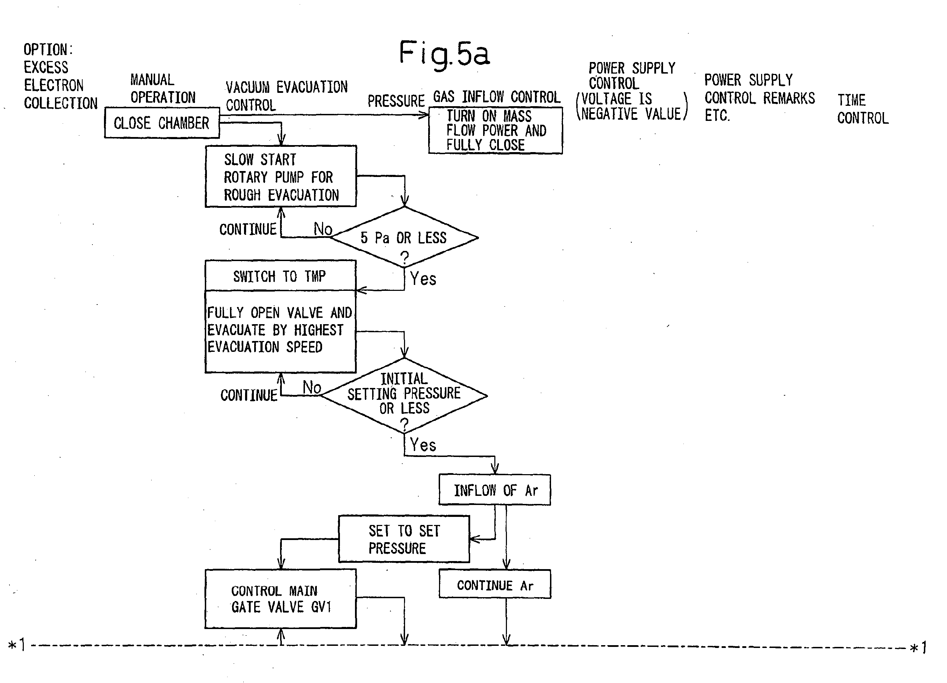

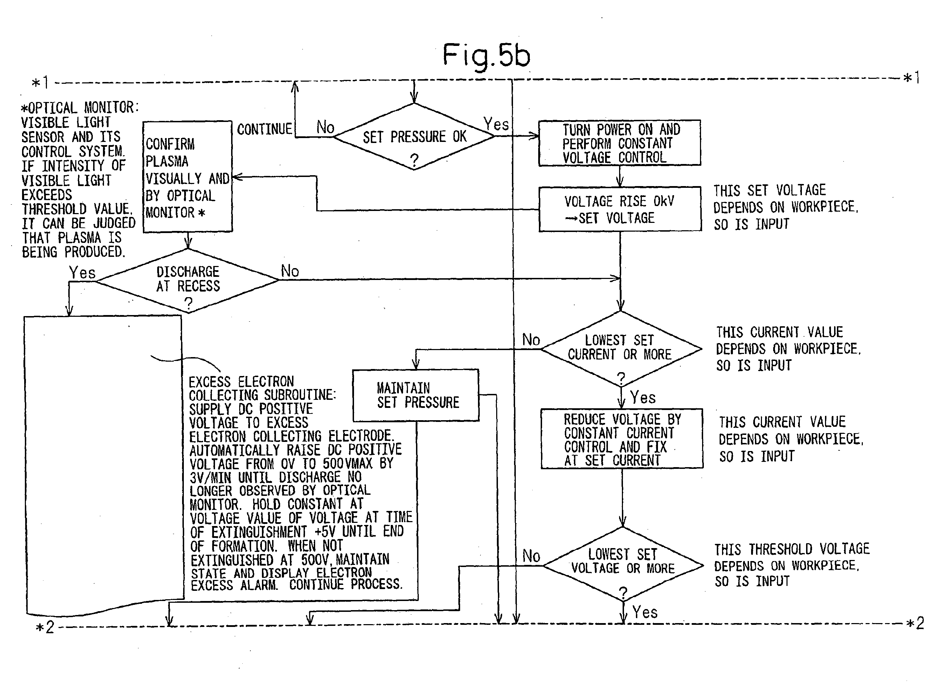

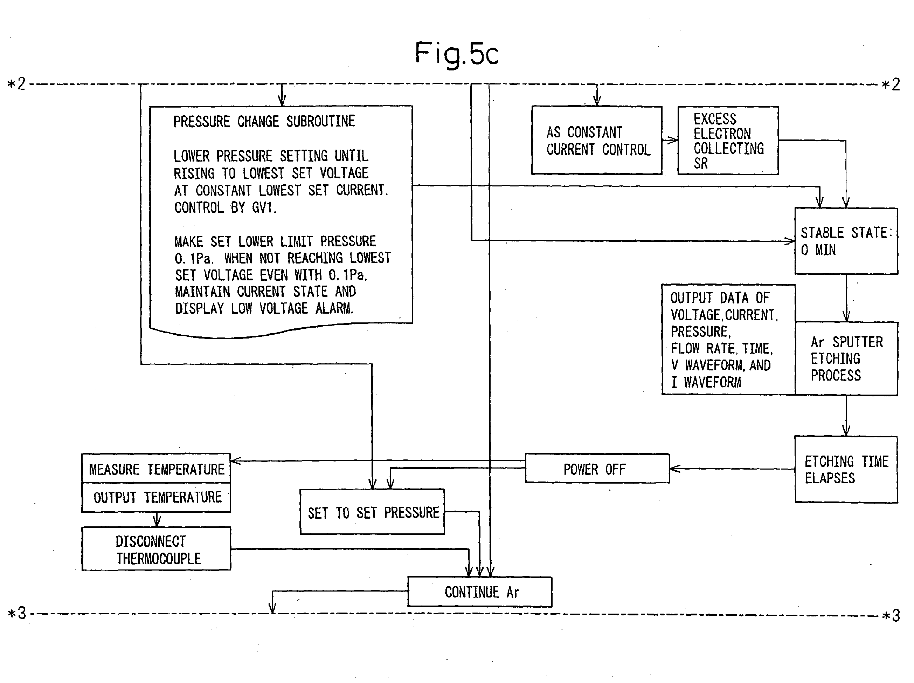

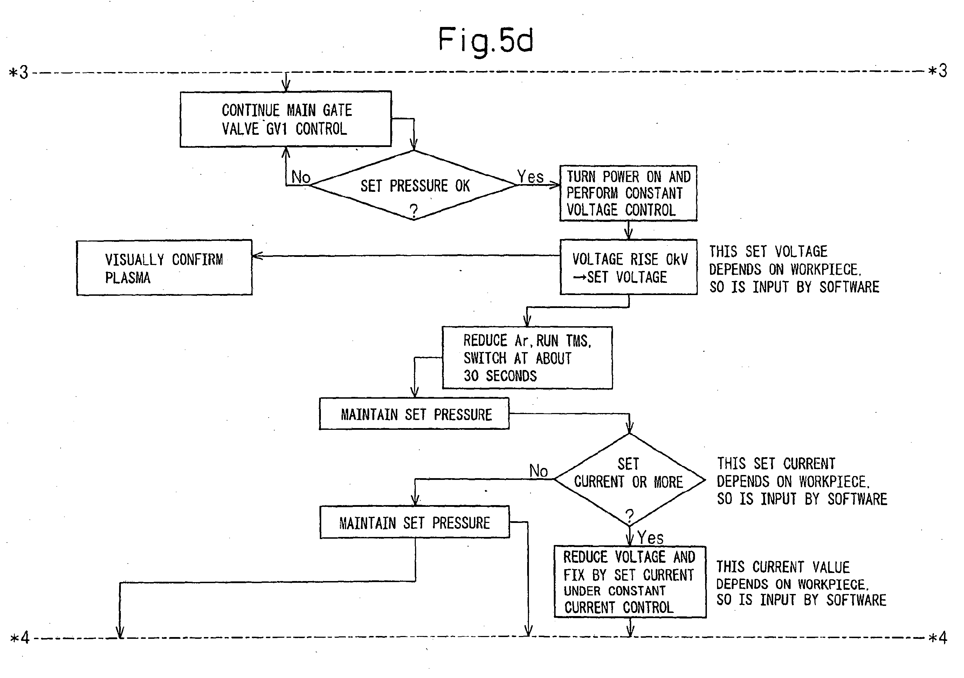

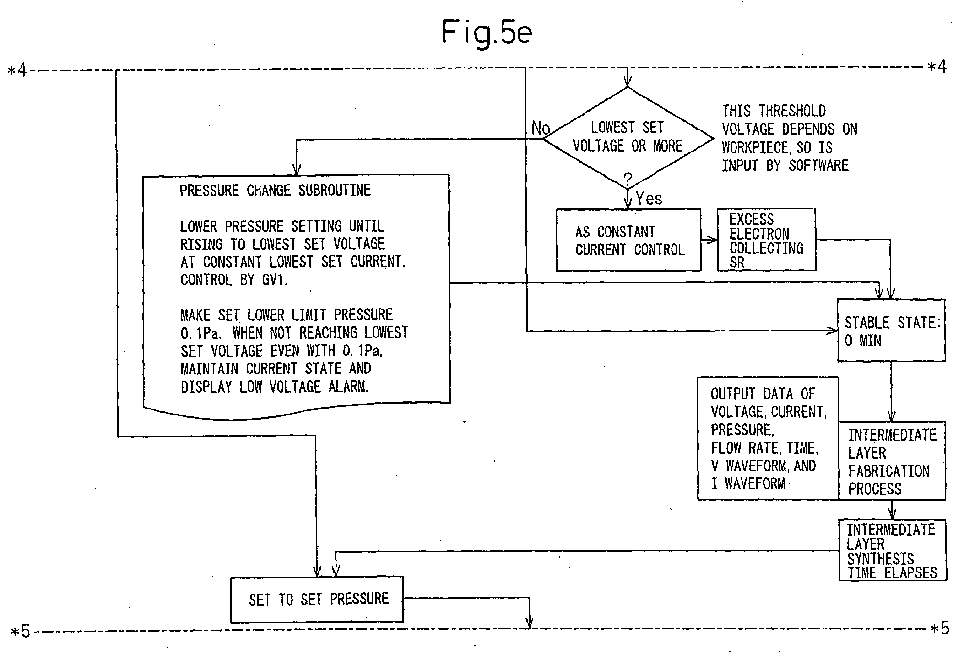

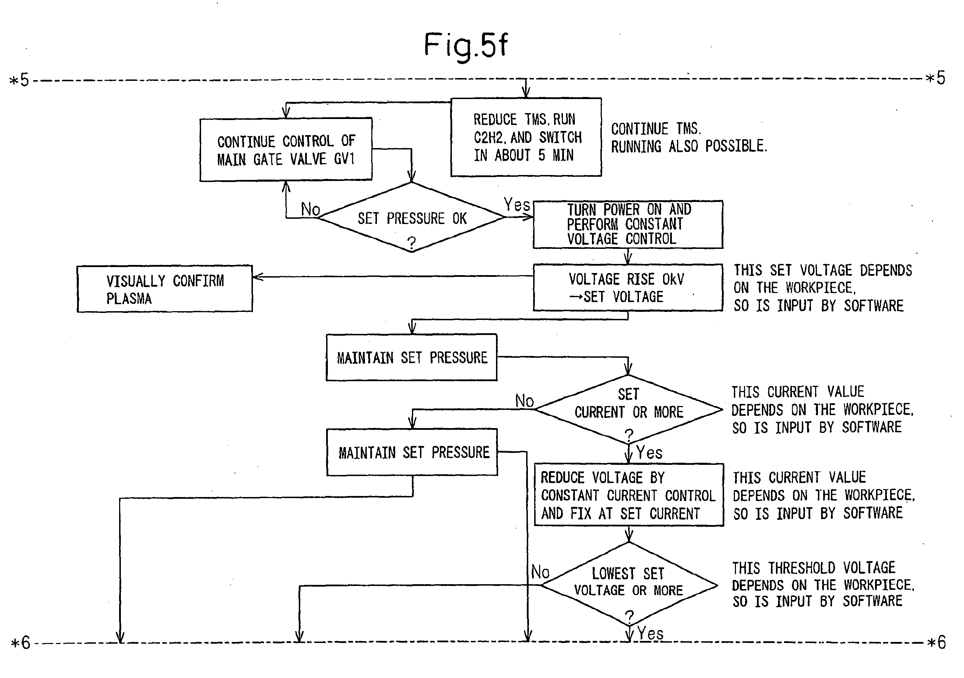

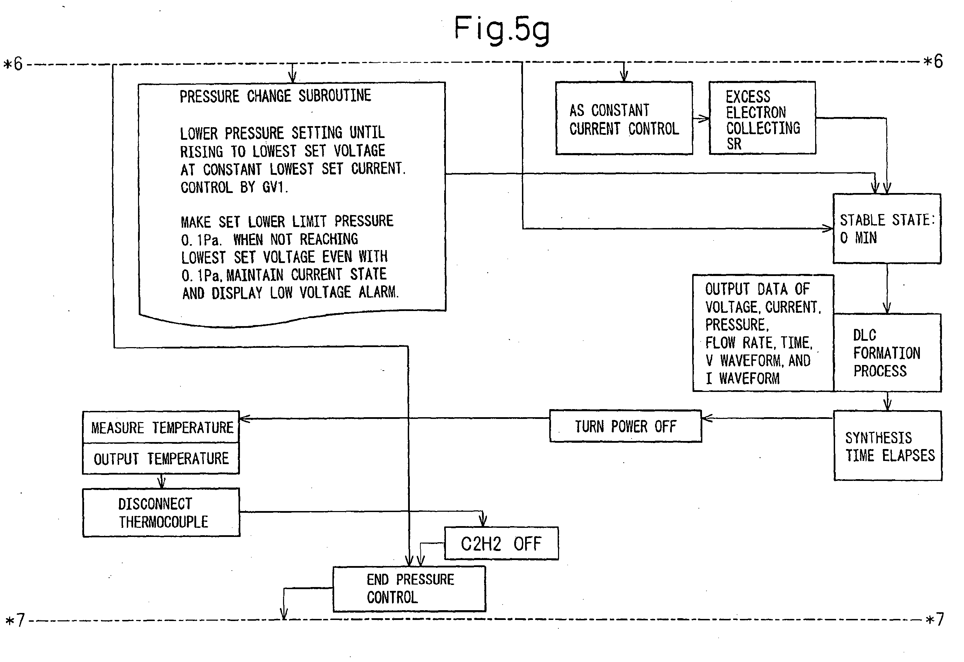

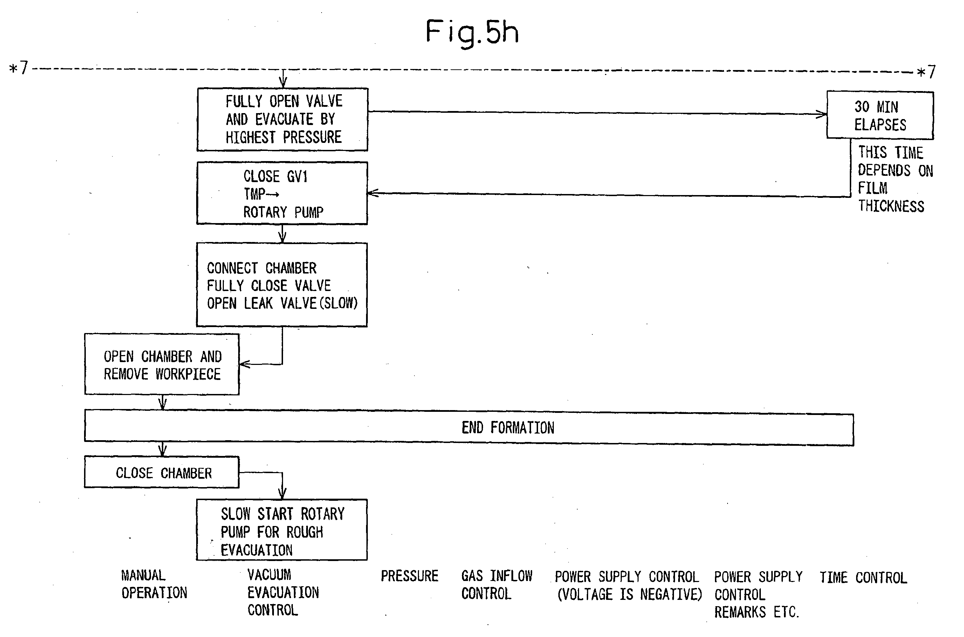

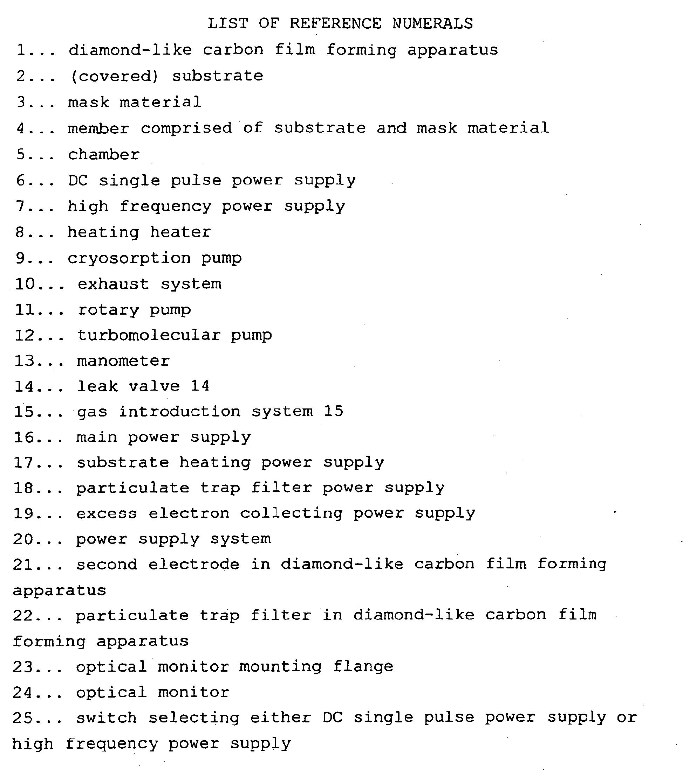

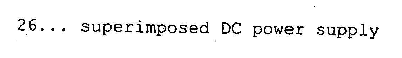

The present apparatus is provided with basic programs for forming DLC films having a 10 GPa or higher nanoindentation hardness on polymer substrates and metal substrates. Flow charts of the preparation of the operating routines and other basic programs of the present apparatus are shown in FIG. 5A to FIG. 5H. For example, as shown in FIG. 5A to FIG. 5H, in the case of a nylon substrate, Ar sputter etching and DLC formation is performed under suitable discharge conditions. The output at the time of the sputter etching and DLC formation, as mentioned above, is controlled by changing the power supply voltage, power supply current, chamber pressure, and excess electron collecting anode voltage to obtain a constant discharge voltage and discharge current. Further, basic programs for DLC formation are prepared for polyethylene, nylon, polyurethane, polypropylene, rubber, epoxy, polyacetal (POM), acryl resin (PMMA), Teflon®, polycarbonate, polyether ether ketone (PEEK), polyamide, polyimide, polyphenylene sulfide (PPS), fiber-reinforced polyether ether ketone (PEEK), fiber-reinforced polyphenylene sulfide (PPS), fiber-reinforced epoxy, ferrous metal material, aluminum alloy, magnesium, or cemented carbide alloy.

Further, in the present apparatus, a cleaning program (cleaning process) for cleaning the inside of the chamber is also provided for each batch. The cleaning conditions differ depending on the substrate at the time of formation performed right before. By selecting the substrate, the inside of the chamber can be automatically cleaned. The gas at the time of cleaning of the present invention may be oxygen, hydrogen, water, or CF₄. By changing the pressure inside the chamber at the time of cleaning between 0.03 Pa to 50 Pa, the parts inside the chamber can be cleaned. When it is necessary to obtain an accurate grasp of the end of the cleaning, the chamber is provided inside it with a mass analysis device and the cleaning is performed until almost no elements other than the introduced gas are detected any longer.

Furthermore, the present apparatus can have added to it a film thickness interference type of optical film thickness monitor when it is necessary to obtain an accurate grasp of the thickness of the DLC film. When operating this monitor, the discharge is automatically made to stop when the film thickness reaches the setting.

The present apparatus can form a DLC film automatically on a substrate of a polymer material and a substrate of a metal material by integrated control of the chamber system, vacuum system, gas introduction system, and power supply system and by a basic program. For example, by closing the door attached to the chamber of the present apparatus, then inputting an instruction for starting operation of the apparatus to a central control device by manual or remote control or by operation on a signal through the Internet etc., it is possible to automatically start the evacuation, raise the temperature of the substrate, introduce argon into the chamber, sputter the argon, measure the substrate temperature, perform nitridation by introduction of nitrogen gas, form an intermediate layer by introduction of tetramethylsilane (TMS), form a DLC film by introduction of acetylene, stop the acetylene gas, purge the chamber by nitrogen gas, measure the temperature, etc., and notify the end by display on the operation panel, a sound and a signal through a dedicated signal line or the Internet, etc. For the formation of the intermediate layer and the DLC film, for example, the process of the [intermediate layer 10 nm thickness → DLC film 100 nm] is repeated 10 times or an [intermediate layer 20 nm → hardness 10 GPa DLC film 500 nm] are formed by a DC single pulse → a hardness 20 GPa DLC film 500 nm is formed by high frequency plasma CVD for formation of multiple layers. After film formation, the worker opens the door attached to the chamber of the present apparatus to take out the member (4), then starts the above-mentioned cleaning process. The present apparatus is **characterized in that** the initial values of the pressure, type and flow rate of the gas, discharge voltage, discharge current, and substrate temperature are set for each of the above steps and in that the power supply set voltage, power supply set current, pressure, substrate heating heater output, particulate filter power supply output, and excess electron collecting power supply output are automatically integratedly controlled. The times of the steps are set by the program, but when using a film thickness meter, the control by time in the program can be changed to control by the thickness of the intermediate layer and the thickness of the DLC layer. Note that, the intermediate layer may also be prepared from the known method of sputtering from a titanium (Ti), chrome (Cr), silicon (Si), tungsten (W), or other target. At this time, the sputtered film thickness is 0.1 to 100 nm.

The present apparatus is set with initial values of the pressure, type and flow rate of the gas, discharge voltage, discharge current, and substrate temperature etc. and integratedly controls the power supply voltage, power supply current, pressure, and excess electron collecting anode voltage as parameters so as maintain the discharge voltage and the discharge current constant. Further, the present apparatus has a mechanism which uses a substrate heating heater to hold the temperature of the substrate constant, so unlike the conventional method of control of only the power supply setting voltage, power supply setting current, and substrate heating heater output, gradually changing the composition from the intermediate layer to the DLC layer also becomes easy. Further, the present invention is **characterized in that** by periodically supplying a gas other than a hydrocarbon during the formation of the DLC, it is possible to easily form a multilayer film comprised of a cyclic structure of a DLC layer and a layer including an element other than carbon and hydrogen.

## Claims

1. A diamond-like carbon film forming apparatus (1) using plasma chemical vapor deposition,
said diamond-like carbon film forming apparatus using plasma chemical vapor deposition provided with:
a cathode electrode of a power supply connected to a member (4) comprised of a substrate (2) surrounded by a conductive mask material (3) having one of a cylindrical shape, a cam shape, a spherical shape, a tubular shape, a combination of block shape and curved shape, a pyramid shape, a bellows, a frustoconical shape, a star shape, and an ovoid shape, of a net or of a plate having a plurality of openings and made of a conductive polymer material,
an anode electrode connected to a wall of a chamber (5) of the diamond-like carbon film forming apparatus (1), and
a DC single pulse power supply (6) and/or high frequency power supply (7) supplying voltage to said member (4),
said apparatus applying a negative single pulse voltage from said DC single pulse power supply (6) or a high frequency voltage from said high frequency power supply (7) between said cathode electrode and said anode electrode so as to form a segment structure diamond-like carbon film on said substrate (2) surrounded by said mask material (3).

2. A diamond-like carbon film forming apparatus as set forth in claim 1, **characterized by** applying a negative single pulse voltage between said cathode electrode and said anode electrode from a superimposed DC power supply (26) connecting to said DC single pulse power supply (6) in series.

3. A diamond-like carbon film forming apparatus as set forth in any one of claims 1 or 2, **characterized in that** said substrate is a polymer material.

4. A diamond-like carbon film forming apparatus as set forth in any one of claims 1 to 3, **characterized in that** said high frequency power supply (7) has a frequency of 13.56 MHz to 60 MHz in range.

5. A diamond-like carbon film forming apparatus as set forth in any one of claims 1 to 4, **characterized by** being provided with a heating heater (8) or ohmic heating mechanism able to heat said substrate (2) to 100°C to 720°C in temperature range and connected to a substrate heating power supply (17).

6. A diamond-like carbon film forming apparatus as set forth in any one of claims 1 to 5, **characterized by** setting the voltage of said DC single pulse power supply (6) to -2kV to - 20kV in range or by setting the output of said high frequency power supply (7) to 40W to 10 kW in range so as to make the temperature of the substrate at the time of formation of said diamond-like carbon film less than 200°C.

7. A diamond-like carbon film forming apparatus as set forth in any one of claims 1 to 6, **characterized in that** said diamond-like carbon film forming apparatus is provided with a particulate trap filter (22), said particulate trap filter is connected to a third DC power supply, and 100 to 7000V of voltage is applied across the cathode and anode to trap the impurity-forming particulate by electrostatic action.

8. A diamond-like carbon film forming apparatus as set forth in any one of claims 1 to 7, **characterized in that** said diamond-like carbon film forming apparatus is provided with a second anode electrode (21), and +5V to +500V of DC voltage is applied to said second anode electrode so that said second anode electrode traps excess electrons in said diamond-like carbon film forming apparatus.

9. A diamond-like carbon film forming apparatus as set forth in any one of claims 1 to 8, **characterized by** being provided with software and a software operating mechanism which, after the start of formation of that diamond-like carbon film, receives as feedback and processes information of a substrate temperature measurement mechanism, an oscilloscope set in a chamber power feed unit or other power feed measurement mechanism, a pressure measurement mechanism inside the chamber, so as to automatically control the DC single pulse power supply voltage and power supply current, high frequency power supply voltage and power supply current, type and feed rate of the film forming feed gas, pressure inside the diamond-like carbon film forming apparatus, power supply voltage and power supply current to the second anode electrode trapping excess electrons, and output of the heating heater or ohmic heating mechanism.

10. A method of forming a diamond-like carbon film using a diamond-like carbon film forming apparatus as set forth in any one of claims 1 to 9, said method of forming a diamond-like carbon film **characterized by**
applying voltage of said DC single pulse power supply (6) or said high frequency power supply (7) between the cathode electrode connected to the member (4) and the anode electrode connected to the wall of said chamber (5) to form a segment structure diamond-like carbon film on said substrate (2) surrounded by said mask material (3).

11. A method of forming a diamond-like carbon film as set forth in claim 10, **characterized by**,
when the member (4) comprised of said substrate (2) surrounded by the conductive mask material (3) having a net shape or a plurality of openings becomes 50°C or higher in temperature, using a mask material having a net shape or a plurality of openings comprised of a Ti-Ni or other shape memory alloy to form a segment structure diamond-like carbon film on said substrate.

## Patentansprüche

1. Vorrichtung (1) zum Bilden eines diamantenähnlichen Kohlenstofffilms unter Verwendung von plasmaunterstützter chemischer Gasphasenabscheidung,
wobei die Vorrichtung zum Bilden eines diamantenähnlichen Kohlenstofffilms unter Verwendung von plasmaunterstützter chemischer Gasphasenabscheidung bereitgestellt ist mit:
einer Kathodenelektrode einer Stromquelle verbunden mit einem Element (4) bestehend aus einem Substrat (2) umgeben von einem leitendem Maskenmaterial (3) mit einem von einer zylindrischen Form, Nockenform, Kugelform, Röhrenform, einer Kombination aus Blockform und Kurvenform, einer Pyramidenform, einem Balg, einer Kegelstumpfform, Sternenform und einer Eierform eines Netzes oder einer Platte mit mehreren Öffnungen und hergestellt aus einem leitenden Polymermaterial,
einer Anodenelektrode verbunden mit einer Wand einer Kammer (5) der Vorrichtung (1) zum Bilden eines diamantenähnlichen Kohlenstofffilms, sowie
einer Einzelimpuls-Gleichstromquelle (6) und/oder eine Hochfrequenz-Stromquelle (7), die das Element (4) mit Spannung versorgt,
worin die Vorrichtung eine negative Einzelimpulsspannung von der Einzelimpuls-Gleichstromquelle (6) oder eine Hochfrequenzspannung von der Hochfrequenz-Stromquelle (7) zwischen die Kathodenelektrode und die Anodenelektrode aufbringt, um so einen diamantenähnlichen Kohlenstofffilm mit Segmentstruktur auf dem Substrat (2) umgeben von dem Maskenmaterial (3) zu bilden.

2. Vorrichtung zum Bilden eines diamantenähnlichen Kohlenstofffilms nach Anspruch 1, **gekennzeichnet durch** Aufbringen einer negative Einzelimpulsspannung zwischen der Kathodenelektrode und der Anodenelektrode von einer übergelagerten Gleichstromquelle (26), die mit der Einzelimpuls-Gleichstromquelle (6) in Reihe geschaltet ist.

3. Vorrichtung zum Bilden eines diamantenähnlichen Kohlenstofffilms nach Anspruch 1 oder 2, **dadurch gekennzeichnet, dass** das Substrat ein Polymermaterial ist.

4. Vorrichtung zum Bilden eines diamantenähnlichen Kohlenstofffilms nach einem der Ansprüche 1 bis 3, **dadurch gekennzeichnet, dass** die Hochfrequenz-Stromquelle (7) einen Frequenzbereich von 13,56 MHz bis 60 MHz aufweist.

5. Vorrichtung zum Bilden eines diamantenähnlichen Kohlenstofffilms nach einem der Ansprüche 1 bis 4, **gekennzeichnet durch** die Bereitstellung mit einem Heizer (8) oder Ohm'schen Heizmechanismus, der fähig ist, das Substrat (2) auf einen Bereich von 100°C bis zu 720°C zu erhitzen und mit einer Stromversorgung (17) zum Heizen des Substrats verbunden ist.

6. Vorrichtung zum Bilden eines diamantenähnlichen Kohlenstofffilms nach einem der Ansprüche 1 bis 5, **gekennzeichnet durch** Festlegen der Spannung der Einzelimpuls-Gleichstromquelle (6) auf einen Bereich von -2 kV bis -20 kV oder **durch** Festlegen der Ausgangsleistung der Hochfrequenz-Stromquelle (7) auf einen Bereich von 40 W bis 10 kW, um so die Temperatur des Substrats im Zeitpunkt der Bildung des diamantenähnlichen Kohlenstofffilms auf weniger als 200°C steigen zu lassen.

7. Vorrichtung zum Bilden eines diamantenähnlichen Kohlenstofffilms nach einem der Ansprüche 1 bis 6, **dadurch gekennzeichnet, dass** die Vorrichtung zum Bilden eines diamantenähnlichen Kohlenstofffilms mit einem Partikelfilter (22) bereitgestellt ist, wobei der Partikelfilter mit einer dritten Gleichstromquelle verbunden ist und eine Spannung von 100 bis 7000 V über die Kathode und Anode aufgebracht wird, um Verunreinigungen bildende Partikel durch Elektrostatik einzufangen.

8. Vorrichtung zum Bilden eines diamantenähnlichen Kohlenstofffilms nach einem der Ansprüche 1 bis 7, **dadurch gekennzeichnet, dass** die Vorrichtung zum Bilden eines diamantenähnlichen Kohlenstofffilms mit einer zweiten Anodenelektrode (21) bereitgestellt wird, und eine Spannung von +5 V bis +500 V auf die zweite Anodenelektrode aufgebracht wird, damit die zweite Anodenelektrode überschüssige Elektronen in der Vorrichtung zum Bilden eines diamantenähnlichen Kohlenstofffilms einfängt.

9. Vorrichtung zum Bilden eines diamantenähnlichen Kohlenstofffilms nach einem der Ansprüche 1 bis 8, **gekennzeichnet durch** die Bereitstellung mit Software und einem Softwarebetriebsmechanismus, der nach dem Beginn der Bildung des diamantenähnlichen Kohlenstofffilm als Rückmeldung Verfahrensinformationen von einem Erfassungsmechanismus der Substrattemperatur, einem Oszilloskop in einer Kammer einer Energiezufuhr oder einem anderen Energiezufuhrerfassungsmechanismus, einem Druckerfassungsmechanismus innerhalb der Kammer erhält, um so die Spannung der Einzelimpuls-Gleichstromquelle und den Versorgungsstrom, die Spannung der Hochfrequenz-Stromquelle und den Versorgungsstrom, die Art und die Einspeisungsrate des filmbildenden Zuflussgases, den Druck innerhalb der Vorrichtung zum Bilden eines diamantenähnlichen Kohlenstofffilms, die Versorgungsspannung und den Versorgungsstrom an die zweite Anodenelektrode, die überschüssige Elektronen einfängt, sowie die Ausgangsleistung des Heizers oder des Ohm'schen Heizmechanismus automatisch zu steuern.

10. Verfahren zur Herstellung eines diamantenähnlichen Kohlenstofffilms durch Verwendung der Vorrichtung zum Bilden eines diamantenähnlichen Kohlenstofffilms nach einem der Ansprüche 1 bis 9, wobei das Verfahren zur Herstellung eines diamantenähnlichen Kohlenstofffilms **gekennzeichnet ist durch**
Aufbringen einer Spannung der Einzelimpuls-Gleichstromquelle (6) oder der Hochfrequenz-Stromquelle (7) zwischen die Kathodenelektrode verbunden mit dem Element (4) und die mit der Wand der Kammer (5) verbundene Anodenelektrode, um eine diamantenähnlichen Kohlenstofffilm mit Segmentstruktur auf dem Substrat (2) umgeben von dem Maskenmaterial (3) zu bilden.

11. Verfahren zur Herstellung eines diamantenähnlichen Kohlenstofffilms nach Anspruch 10, **gekennzeichnet durch**
wenn das aus dem Substrat (2) umgeben von dem leitenden Material (3) mit einer Netzform oder mit mehreren Öffnungen bestehende Element (4) eine Temperatur von 50°C oder mehr aufweist, Verwenden eines Maskenmaterials mit Netzform oder mehreren Öffnungen bestehend aus einer Ti-Ni oder anderen Formgedächtnislegierung, um einen diamantenähnlichen Kohlenstofffilm mit Segmentstruktur auf dem Substrat zu bilden.

## Revendications

1. Appareil de formation de film de carbone diamantin (1) utilisant un dépôt chimique en phase vapeur au plasma,
ledit appareil de formation de film de carbone diamantin utilisant un dépôt chimique en phase vapeur au plasma est pourvu :
d'une électrode de cathode d'une alimentation connectée à un élément (4) composé d'un substrat (2) entouré par un matériau de masque conducteur (3) ayant l'une d'une forme cylindrique, d'une forme de came, d'une forme sphérique, d'une forme tubulaire, d'une combinaison d'une forme de bloc et d'une forme incurvée, d'une forme pyramidale, d'un soufflet, d'une forme conique tronquée, d'une forme d'étoile, et d'une forme ovoïde, d'un filet ou d'une plaque comportant une pluralité d'ouvertures et réalisée en un matériau polymère conducteur,
d'une électrode d'anode connectée à une paroi d'une chambre (5) de l'appareil de formation de film de carbone diamantin (1), et
d'une alimentation impulsionnelle simple continue (6) et/ou d'une alimentation haute fréquence (7) fournissant une tension audit élément (4),
ledit appareil appliquant une tension impulsionnelle simple négative de ladite alimentation impulsionnelle simple continue (6) ou une tension haute fréquence de ladite alimentation haute fréquence (7) entre ladite électrode de cathode et ladite électrode d'anode de manière à former un film de carbone diamantin à structure segmentée sur ledit substrat (2) entouré par ledit matériau de masque (3).

2. Appareil de formation de film de carbone diamantin selon la revendication 1, **caractérisé par** l'application d'une tension impulsionnelle simple négative entre ladite électrode de cathode et ladite électrode d'anode à partir d'une alimentation continue superposée (26) connectée à ladite alimentation impulsionnelle simple continue (6) en série.

3. Appareil de formation de film de carbone diamantin selon l'une quelconque des revendications 1 ou 2, **caractérisé en ce que** ledit substrat est un matériau polymérique.

4. Appareil de formation de film de carbone diamantin selon l'une quelconque des revendications 1 à 3, **caractérisé en ce que** ladite alimentation haute fréquence (7) a une fréquence dans la plage de 13,56 MHz à 60 MHz.

5. Appareil de formation de film de carbone diamantin selon l'une quelconque des revendications 1 à 4, **caractérisé en ce qu'**il est pourvu d'un dispositif de chauffage (8) ou d'un mécanisme de chauffage ohmique capable de chauffer ledit substrat (2) dans une plage de température de 100 °C à 720 °C et connecté à une alimentation de chauffage de substrat (17).

6. Appareil de formation de film de carbone diamantin selon l'une quelconque des revendications 1 à 5, **caractérisé par** le réglage de la tension de ladite alimentation impulsionnelle simple continue (6) dans la plage de -2 kV à -20 kV ou par le réglage de la sortie de ladite alimentation haute fréquence (7) dans la plage de 40 W à 10 kW de manière à amener la température du substrat à l'instant de la formation dudit film de carbone diamantin à une valeur inférieure à 200 °C.

7. Appareil de formation de film de carbone diamantin selon l'une quelconque des revendications 1 à 6, **caractérisé en ce que** ledit appareil de formation de film de carbone diamantin est pourvu d'un filtre de piégeage de matière particulaire (22), ledit filtre de piégeage de matière particulaire est connecté à une troisième alimentation continue, et une tension entre 100 V et 7 000 V est appliquée entre la cathode et l'anode pour piéger la matière particulaire formant des impuretés par une action électrostatique.

8. Appareil de formation de film de carbone diamantin selon l'une quelconque des revendications 1 à 7, **caractérisé en ce que** ledit appareil de formation de film de carbone diamantin est pourvu d'une deuxième électrode d'anode (21), et une tension continue de +5 V à +500 V est appliquée à ladite deuxième électrode d'anode de sorte que ladite deuxième électrode d'anode piège les électrons en excès dans ledit appareil de formation de film de carbone diamantin.

9. Appareil de formation de film de carbone diamantin selon l'une quelconque des revendications 1 à 8, **caractérisé en ce qu'**il est pourvu d'un logiciel et d'un mécanisme de mise en oeuvre de logiciel qui, après le début de la formation de ce film de carbone diamantin, reçoit en tant que rétroaction et traite les informations d'un mécanisme de mesure de température de substrat, d'un oscilloscope placé dans une unité de fourniture de puissance de chambre ou un autre mécanisme de mesure de fourniture de puissance, d'un mécanisme de mesure de pression à l'intérieur de la chambre, de manière à commander automatiquement la tension d'alimentation impulsionnelle simple continue et le courant d'alimentation, la tension d'alimentation haute fréquence et le courant d'alimentation, le type et le débit du gaz d'alimentation de formation de film, la pression à l'intérieur de l'appareil de formation de film de carbone diamantin, la tension d'alimentation et le courant d'alimentation vers la deuxième électrode d'anode piégeant les électrons en excès, et la sortie du dispositif de chauffage ou du mécanisme de chauffage ohmique.

10. Procédé de formation d'un film de carbone diamantin utilisant un appareil de formation de film de carbone diamantin selon l'une quelconque des revendications 1 à 9, ledit procédé de formation d'un film de carbone diamantin étant **caractérisé par**
l'application d'une tension de ladite alimentation impulsionnelle simple continue (6) ou de ladite alimentation haute fréquence (7) entre l'électrode de cathode connectée à l'élément (4) et l'électrode d'anode connectée à la paroi de ladite chambre (5) pour former un film de carbone diamantin à structure segmentée sur ledit substrat (2) entouré par ledit matériau de masque (3).

11. Procédé de formation d'un film de carbone diamantin selon la revendication 10, **caractérisé par**
lorsque l'élément (4) composé dudit substrat (2) entouré par le matériau de masque conducteur (3) ayant une forme de filet ou une pluralité d'ouvertures atteint une température de 50 °C ou plus, l'utilisation d'un matériau de masque ayant une forme de filet ou une pluralité d'ouvertures composé d'un alliage de Ti-Ni ou d'un autre alliage à mémoire de forme pour former un film de carbone diamantin à structure segmentée sur ledit substrat.
